# EUROPEAN PATENT APPLICATION

(11) **EP 2 509 105 A1**
(43) Date of publication of application: **10.10.2012**
(21) Application number: 11161040.8
(22) Date of filing: 04.04.2011
(51) Int. Cl.: H01L 23/64, H01L 23/66

(54) **Semiconductor device having improved performance for high RF output powers**

(71) Applicant: NXP B.V., 5656 AG Eindhoven (NL)
(72) Inventor: Rijs, Van, Fred, 5656 AG, Eindhoven (NL)
(74) Representative: Krott, Michel

(57) **Abstract**

The invention relates to a semiconductor device comprising: i) a first substrate region (10) comprising an active element (15), the active element (15) comprising an electrical node; ii) a plurality of external contact regions (EBP) for being wire bonded to other parts (2, 3, 20, 30, 40, 50) of the semiconductor device, wherein the external contact regions (EBP) are each electrically connected to the electrical node of the active element (15); iii) a second substrate region (11) having a lower loss than the first substrate region (10), wherein loss is defined as resistive loss and/or loss due to eddy-currents in the respective substrate region (10, 11), and iv) a current-compensation conductor (EBB, EBB1, EBB2) provided on the second substrate region (11) and being electrically connected to at least two of the plurality of external contact regions (EBP). The invention provides a semiconductor device with a current-compensation conductor having an improved RF performance, because the current-compensation conductor is provided on a low-loss substrate.

## Description

### FIELD OF THE INVENTION

The invention relates to a semiconductor device having a current-compensation conductor.

### BACKGROUND OF THE INVENTION

An RF power amplifier is a type of electronic amplifier used to convert a low-power radio-frequency signal into a larger signal of significant power, typically for driving the antenna of a transmitter. It is usually optimized to have high efficiency, high output Power (P1 dB) compression, good return loss on the input and output, good gain, and optimum heat dissipation.

The basic applications of the RF power amplifier include driving to another high power source, driving a transmitting antenna, microwave heating, and exciting resonant cavity structures. Among these applications, driving transmitter antennas is most well known. The transmitter-receivers are used not only for voice and data communication but also for weather sensing (in the form of a radar). An RF power amplifier generally comprises of a package having a source lead (plate shaped), a drain lead, and a gate lead. Inside the package there is provided a semiconductor die in which the RF power transistor is manufactured When designed for high power levels the die may only comprise the RF LDMOS transistor on the die. When designed for lower power levels, e.g. for drivers, the die may also comprise integrated matching structures. Furthermore, the die may also contain ESD-protection structures at the gate-side. The die is wire bonded to the respective leads. Often some further components, such as capacitors, are provided as well. These capacitors form together with the bond wires a so-called impedance matching network. For (electrical) performance reasons, the bond wires are generally kept as short as possible. However, the dimensioning of the impedance matching network may imply that the bond wires are made with a specific length.

Power amplifiers (PA's) for base stations use predominantly laterally-diffused metal-oxide-semiconductor (LDMOS) technology. The trend in base station PA's is towards higher peak power capabilities to be able to transmit more channels for larger data capacity. A needed RF peak power of about 1 kW, when implemented with a three-way Doherty concept using 3 transistors, needs a transistor with a P1 dB peak power of 320 W whereas currently a peak power of 200 W was state of the art. The high power levels come at the cost of loss in performance with loss in power efficiency as the most important one. This is known as the power (efficiency) scaling issue.

The power-added-efficiency (PAE) may be plotted as function of total gate-width (Wg) of the LDMOS transistor. Two effects may be observed from such a plot. Firstly, the efficiency degrades for larger Wg for a single die. Secondly, the efficiency decreases additionally when multiple dies (e.g. 3) are put in parallel. The power-added efficiency is defined as the RF output power (Pout) minus the RF input power (Pin) divided by the DC supply power (Pdc). Sometimes also the term "efficiency" or "drain-efficiency" is used, which is defined as the RF output power (Pout) divided by the DC supply power. For a large transistor gain (thus low RF input power Pin) both definitions become almost the same.

One of the root causes of the efficiency degradation are distribution effects. The LDMOS transistor consists of a number of gate and drain fingers in parallel in an interdigitated design. Each finger can be seen as an individual power amplifier which is fed at the input via a splitter network and all the output powers are combined at the output by a combiner network.

In practice, the input and output combiner network comprise the respective transistor package leads and the respective internal matching circuitry and the performance of the die cannot be seen independently from its environment. At RF frequencies, the wavelength of the input signal becomes comparable to the dimensions of the package and the individual amplifiers will be steered non-uniformly with different phase and amplitudes at the input and will see different load-impedances at the output. The total power will be smaller than the sum of the individual amplifiers and scaling effects become apparent.

Two root causes for the non-uniform steering and loading are:
1. The wave-front in the package lead is non-uniform due to different propagation lengths.
2. The coupling between bond-wires will introduce non-uniform impedance distribution.

In a fully-packaged LDMOS transistor according to the prior art, the effect of the non-uniform steering and loading is reduced by two large metal strips that are placed on the transistor die at the gate and drain side. These metal strips are also used as a bond-bar for the bond-wires. They effectively "short circuit" all gates and drains of the LDMOS fingers at the bondpads of the die. It must be noted that at RF frequencies the inductance of the bar is no longer negligible which prevents the bond-bar from being a real short-circuit. Therefore, the distance between bond-wires should not be too large. As a result, the gate and drain voltages and current of the individual amplifiers are more equalized. In order for the metal strips to equalize the steering under the non-uniform driving conditions, large currents have flow along the strip.

A problem of the known packaged LDMOS transistor is that the RF power-added-efficiency is still lower than desired.

### SUMMARY OF THE INVENTION

It is a first object of the invention to provide a semiconductor device having an improved RF performance.

The invention is defined by the independent claims. The dependent claims define advantageous embodiments.

In a first aspect, in accordance with the first object, the invention relates to a semiconductor device as claimed in claim 1.

The effect of the features of the invention is as follows. In the semiconductor device of the invention a plurality of external contact regions (such as bondpads) is connected to the electrical node (such as an input or an output) of the first active element. In operational use of the device external connections (such as bond wires) are connected to the external contact regions. A current-compensation conductor is connected to at least two of the plurality of external contact regions. When the semiconductor device is being operated at high operating frequencies, such as RF frequencies, the impedance of connections to the first active element starts to play an important role. This is particularly the case for the external connections to the external contact regions. Coupling effects (inductive and/or capacitive) between the connections may result in different impedances of the respective connections. These different impedances may subsequently result in different propagation times over the connections. The current-compensation conductor ensures that the voltages on and current through the respective external contact regions are more equal. However, in case of large differences in impedance between the respective connections to the at least two of the plurality of external contact regions that are connected to the current-compensation conductor large currents may flow through the current-compensation conductor. At RF frequencies the current in the current-compensation conductor will induce a return-current in the substrate region onto which the conductor is provided. Such return-currents results in additional losses due to resistive effects as well as induced eddy-currents. The invention resolves this problem by moving the current-compensation conductor to a second substrate region having a lower loss than the first substrate region. As a consequence the overall loss of the semiconductor device is reduced and thus the RF performance is increased.

In an embodiment of the semiconductor device in accordance with the invention the plurality of the external contact regions is provided on the second substrate region. Having provided two substrate regions a designer has the choice to place the external contact regions either on the first substrate region, on the second substrate region or on both (in any ratio). This embodiment complies with the second option.

In an embodiment of the semiconductor device in accordance with the invention the current-compensation conductor comprises the plurality of external contact regions. This embodiment is very advantageous, because the current-compensation conductor effectively performs two functions, namely that of current-compensation and that of providing an interface for external connections (such as bond wires).

Alternatively, in another embodiment the current-compensation conductor may also be provided as additional part that is electrically connected to the plurality of external contact regions. The advantage of this embodiment is that the current-compensation conductor may be independently optimized for the current-compensation function, while the external contact regions may be independently optimized for the external connections, such as bond wires.

An embodiment of the semiconductor device in accordance with the invention further comprises a plurality of intermediate contact regions for connecting the plurality of external contact regions to the electrical node. This embodiment is particularly advantageous in case the external contact regions are on the second substrate region. The plurality of intermediate contact regions may then be provided on the first substrate region and may be connected to the electrical node of the active element using conventional interconnect technology. The connection between the external contact regions and the electrical node may now be completed by connecting respective ones of the plurality of external contact regions to respective ones of the plurality of intermediate contact regions, for example using bond wires.

In an embodiment of the semiconductor device in accordance with the invention the plurality of the external contact regions is provided on the first substrate region. Having provided two substrate regions a designer has the choice to place the external contact regions either on the first substrate region, on the second substrate region or on both (in any ratio). This embodiment complies with the first option.

An embodiment of the semiconductor device in accordance with the invention further comprises a plurality of intermediate contact regions for connecting the plurality of external contact regions to the current-compensation conductor. This embodiment is particularly advantageous in case the external contact regions are on the first substrate region. The plurality of intermediate contact regions may then be provided on the second substrate region and may be connected to the current-compensation conductor using conventional interconnect technology. The connection between the current-compensation conductor and the electrical node may now be completed by connecting respective ones of the plurality of external contact regions to respective ones of the plurality of intermediate contact regions, for example using bond wires.

Alternatively, in another embodiment the current-compensation conductor may comprise the plurality of intermediate contact regions. This embodiment is very advantageous, because the current-compensation conductor effectively performs two functions, namely that of current-compensation and that of providing an interface for the connections to the external contact regions (such as bond wires).

As will be apparent from the above discussed embodiments the intermediate contact regions may be in or on the first substrate region in case the external contact regions are in or on the second substrate region. In this case the plurality of intermediate contact regions are configured for connecting the plurality of external contact regions to the electrical node. Alternatively, the intermediate contact regions may be in or on the second substrate region in case the external contact regions are in or on the first substrate region. In this case the plurality of intermediate contact regions are configured for connecting the plurality of external contact regions to the current-compensation conductor.

In an embodiment of the semiconductor device in accordance with the invention the plurality of external contact regions is connected to the plurality of intermediate contact regions by means of bond wires. Bond wires constitute a convenient connection means for electrically connecting said parts in particular when the first substrate region and the second substrate region are on different substrates or on different levels on the same substrate. Moreover, wire bonding is a well-known technique within a production environment.

Notwithstanding the previous embodiment other connection means (such as metal tracks) may be used to establish the connection between the external contact regions and the intermediate contact regions. In case no bond wires are used, the intermediate contact regions need not be bond pads.

In an embodiment of the semiconductor device in accordance with the invention the first substrate region and second substrate region are provided on separate substrates. This embodiment is advantageous because for the second substrate region a very a simple dielectric substrate may be taken, while the first substrate region is optimized for integration of the active element.

In an embodiment of the semiconductor device in accordance with the invention the first substrate region and second substrate region are provided on or form part of a single substrate. The substrate may become more costly as it must feature two different RF characteristics in terms of loss. Nevertheless, this embodiment is advantageous in terms of handling during manufacture, i.e. there is no need to place the second substrate region separately (for instance on a source flange of an RF LDMOS transistor package).

In an embodiment of the semiconductor device in accordance with the invention the active element comprises a further electrical node. The semiconductor device further comprises: i) a plurality of further external contact regions for being wire bonded to further other parts of the semiconductor device, wherein the further external contact regions are each electrically connected to the further electrical node of the active element; ii) a third substrate region having a lower loss than the first substrate region, wherein loss is defined as resistive loss and/or loss due to eddy-currents in the respective substrate region, and iii) a further current-compensation conductor provided on the third substrate region and being electrically connected to at least two of the plurality of further external contact regions. This embodiment has an even better RF performance, because the current-compensation technique of the invention is now applied to more than one node of the active element.

In an embodiment of the semiconductor device in accordance with the invention the first substrate region comprises one of CMOS technology, GaN technology, or RF LDMOS technology. The invention is advantageous in any of these technologies, but is not limited thereto.

In an embodiment of the semiconductor device in accordance with the invention the active element comprises an RF power transistor, such as an RF LDMOS transistor. The invention is particularly advantageous in this embodiment, because such transistors are designed to operate in frequency ranges in which current-compensation techniques make a significant difference.

In an embodiment of the semiconductor device in accordance with the invention the RF LDMOS transistor comprises a plurality of individual transistors connected in parallel. Those individual transistors may be connected in parallel by means of an input splitter network connecting respective gates of the individual transistors, and a combiner network connecting all respective drains of the individual transistors. Invention is particularly advantageous in this embodiment, because such transistor configuration may result in different propagation lengths for the individual transistors and, moreover, non-uniform impedance distribution for the individual transistors.

In an embodiment of the semiconductor device in accordance with the invention the electrical node is an output of an amplifier circuit, such as a drain of an RF power transistor (e.g. LDMOS transistor). The invention is particularly advantageous on an output of an amplifier circuit, because, in the prior art solution, the compensation currents on the output side not only reduce the gain of the amplifier circuit, but also reduce the efficiency. In the invention, however, the current-compensation conductor is provided on the second, low-loss, substrate, which increases the positive effect on the efficiency.

In an embodiment of the semiconductor device in accordance with the invention the further electrical node is an input of an amplifier circuit, such as a gate of an RF power transistor (e.g. LDMOS transistor). Notwithstanding, the previous embodiment the invention has also a positive effect (losses are reduced) on the efficiency when being applied to the invention of the amplifier circuit.

It must be stressed that the positive effect of the invention is already noticeable in case, next to a traditional current-compensation conductor on the first substrate region (as what is done in the prior art), an (additional) current-compensation conductor is provided on the second, low-loss, substrate region. However, the best effect is achieved in case the current-compensation conductor is left out or at least interrupted. The more the compensation conductor on the first substrate is interrupted, the less compensation current will flow above the first substrate region and the lower the loss (and the higher the efficiency).

These and other aspects of the invention are apparent from and will be elucidated with reference to the embodiments described hereinafter.

### BRIEF DESCRIPTION OF THE DRAWINGS

In the drawings:
Fig. 1 shows a packaged semiconductor device as known from the prior art;
Fig. 2 shows the power-efficiency scaling issue;
Fig. 3 shows a schematic representation of an LDMOS transistor which comprises a plurality of individual power amplifier transistors connected in parallel;
Fig. 4 shows a front-view of part of a packaged LDMOS transistor of the prior art;
Fig. 5 shows a top-view of the LDMOS transistor of Fig. 4;
Fig. 6 shows non-uniform current distribution in gate bond-wires due to inductive coupling between the wires;
Fig. 7 shows part of a semiconductor device in accordance with a first embodiment the invention;
Fig. 8 shows part of a semiconductor device in accordance with a second embodiment of the invention;
Fig. 9 shows part of a semiconductor device in accordance with a third embodiment of the invention;
Fig. 10 shows part of a semiconductor device in accordance with a fourth embodiment of the invention;
Fig. 11 shows a front-view of part of a packaged LDMOS transistor package in accordance with a further embodiment of the invention;
Fig. 12 shows a top-view of the LDMOS transistor of Fig. 11;
Fig. 13 shows a top-view of part of a packaged LDMOS transistor package in accordance with yet a further embodiment of the invention, and
Figs. 14 to 16 illustrate a plurality of variations of the semiconductor device in accordance with various embodiments of the invention.

### List of reference numerals:

- 1: first conductive terminal / source / source lead (flange) of LDMOS transistor
- 2: second conductive terminal (drain) / gate lead of LDMOS transistor
- 3: third conductive terminal (gate) / drain lead of LDMOS transistor
- 5: electrically insulating member
- 6: recess (in electrically insulating member)
- 7: insulating cover (such as ceramic)
- SD: power-added-efficiency scaling for single die
- MD: power-added-efficiency scaling for multi-die (3 dies)
- PAE: power-added-efficiency
- Wg: total gate width of LDMOS transistor
- INP: input of LDMOS transistor
- OUTP: output of LDMOS transistor
- T1, T2..TN: individual power amplifiers (transistors) that are connected in parallel in LDMOS transistor
- SN: splitter network
- CN: combiner network
- CD: simulated current distribution in gate bond-wires
- GW: number of the respective gate bond wire in which current is simulated
- 8 10: semiconductor die with LDMOS transistor / first substrate region
- 20: first impedance-matching capacitor at gate-side of LDMOS transistor
- 21: bonding region on first impedance-matching capacitor
- 30: second impedance-matching capacitor at drain-side of LDMOS transistor
- 31: bonding region on second impedance-matching capacitor
- LG1: bond-wires from gate terminal to first impedance-matching capacitor
- LG2: bond-wires from first impedance-matching capacitor to gate lead
- Ll: bond-wires from drain terminal to second impedance-matching capacitor
- LD: bond-wires from drain terminal to drain lead
- BBG: bond-bar on first substrate region at gate-side
- BBD: bond-bar on first substrate region at drain-side
- CC: compensation current
- 11: second substrate region
- 15: active element on semiconductor device (such as LDMOS transistor)
- IBP: intermediate bondpads (intermediate contact regions)
- EBP: external bondpads (external contact regions)
- EBB: external bond-bar (current-compensation conductor) on second substrate region
- 17: bond-wires from intermediate bondpads to external bondpads
- 18: bond-wires from external bondpads to external parts (such as lead)
- 18': shifted bond-wires (to current-compensation conductor)
- LC: bond-wires from drain terminal to external bond-bar (current-compensation conductor)
- Ll': bond-wires from external bond-bar to second impedance-matching capacitor
- LD': bond-wires from external bond-bar to drain lead
- BBDI: interrupted bond-bar on first substrate region at drain-side
- 10a: first semiconductor die / first substrate region
- 10b: second semiconductor die / first substrate region
- 12: third substrate region
- BW: bond-wires
- BWT: bond-wire tips (locations where connection makes electrical contact with bond-pads)
- BBGI: interrupted bond-bar on first substrate region at gate side of LDMOS transistor
- BBDI: interrupted bond-bar on first substrate region at drain side of LDMOS transistor
- EBB1: external bond-bar at drain side of LDMOS transistor
- EBB2: external bond-bar at gate side of LDMOS transistor
- CCLL: low-loss compensation current through external bond-bars on second substrate region
- CCHL: high-loss compensation current through bond-bars on first-substrate region
- BBG1: first bond-bar on first substrate region at gate-side
- BBG2: second bond-bar on first substrate region at gate-side
- BBD1: first bond-bar on first substrate region at drain-side
- BBD2: second bond-bar on first substrate region at gate-side
- EBB1a: first external bond-bar at drain side of LDMOS transistor
- EBB1 b: second external bond-bar at drain side of LDMOS transistor
- EBB2a: first external bond-bar at gate side of LDMOS transistor
- EBB2b: second external bond-bar at gate side of LDMOS transistor

### DETAILED DESCRIPTION OF THE PREFERRED EMBODIMENT

In order to facilitate the discussion of the detailed embodiments a few expressions are defined hereinafter.

In this description the term "package" refers to surrounding components that are added to a semiconductor chip, which components are required to connect the chip to an external electronic circuit. The semiconductor chip is typically wire bonded to leads (external terminals). However, package may also refer to a multi-chip module, i.e. next to the semiconductor chip at least one further (passive) component may be provided and wire bonded to the external terminals. An example of such further component is a chip comprising the impedance matching network for the RF LDMOS transistor.

In this description the term "terminal" refers to a pin of the (packaged) device which may be electrically connected to an electronic circuit. Such terminal is sometimes also being referred to as "lead".

In this description the "front-side" of a semiconductor device is defined as the side of the semiconductor device at which the bond pads are provided. This side also being referred to as the first side in this description. The "back-side" of the semiconductor device is defined as the side opposite to the front-side, i.e. the side which is fixed to the first conductive terminal. This side also being referred to as the second side in this description. It must also be noted that throughout the description the same side definitions are used for the layers and components within the package and the packaged semiconductor device.

In this description the term "RF power amplifier" refers to a circuit used to convert a low-power radio-frequency signal into a larger signal of significant power, typically for driving the antenna of a transmitter

In this description the term "active element" is defined as any electrical component on a semiconductor chip which may be used to make an active circuit (an output which is controlled by an input voltage or current). Examples such an active element are a transistor (in all possible varieties), a diode, a triode, a thyristor, and the like.

In this description the term "electrical node" is defined as one of an input node, an output node, or a combination thereof. However, in accordance with invention the term "electrical node" may also refer to a plurality of equivalent nodes in a plurality of circuits that are to be connected in parallel. Expressed differently, this plurality of nodes in the parallel connection is intended to carry the same voltages and currents, thereby effectively forming a virtually single node. In the invention it is possible that all such nodes are connected together on-chip, but also that this is done off-chip.

In the description hereinafter the invention is explained when being applied to an LDMOS power transistor (in a package). Modern LDMOS dies are designed in such a way that the gate and drain contacts are at the topside of the die and the source contact is on the backside of the die. The LDMOS packages are designed to fit this configuration. The gate and drain can be connected to the leads through bond wires. The source is connected to the bottom (lead) of the package (flange) using the backside contact of the die. The flange acts as a third lead. This configuration ensures a very short connection between the die and the third lead (source).

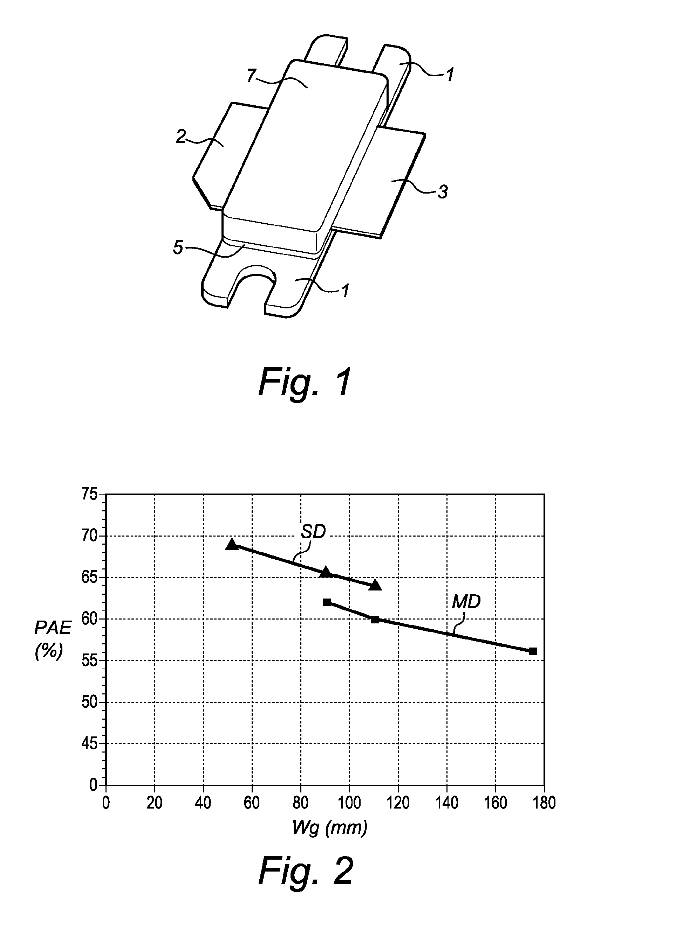

Fig. 1 shows a packaged semiconductor device as known from the prior art. The packaged semiconductor device comprises a source terminal 1 (or contact) which is plate-shaped and which extends to the exterior of the package for being connected to an electronic circuit. The packaged semiconductor device further comprises a drain terminal 2, and a gate terminal 3, which are electrically insulated from the source terminal 2 by a (ring-shaped) electrically insulating member 5, and which also extend to the exterior of the package for being connected to the electronic circuit. The package semiconductor device further comprises an insulating cover 7 covering part of the gate terminal 2, part of the drain terminal 3, and the electrically insulating member 5. The electrically insulating member 5 and the insulating cover 7 may comprise materials such as ceramic material. The source terminal 1 may comprise materials such as copper-tungsten (CuW) or CBC (in case of a GaN semiconductor die). The drain terminal 2 and the gate terminal 3 may comprise materials such as Alloy42, which is an alloy comprising iron. The insulating cover may be glued or soldered to the package. In Fig. 1 the semiconductor chip is contained within the package and not visible.

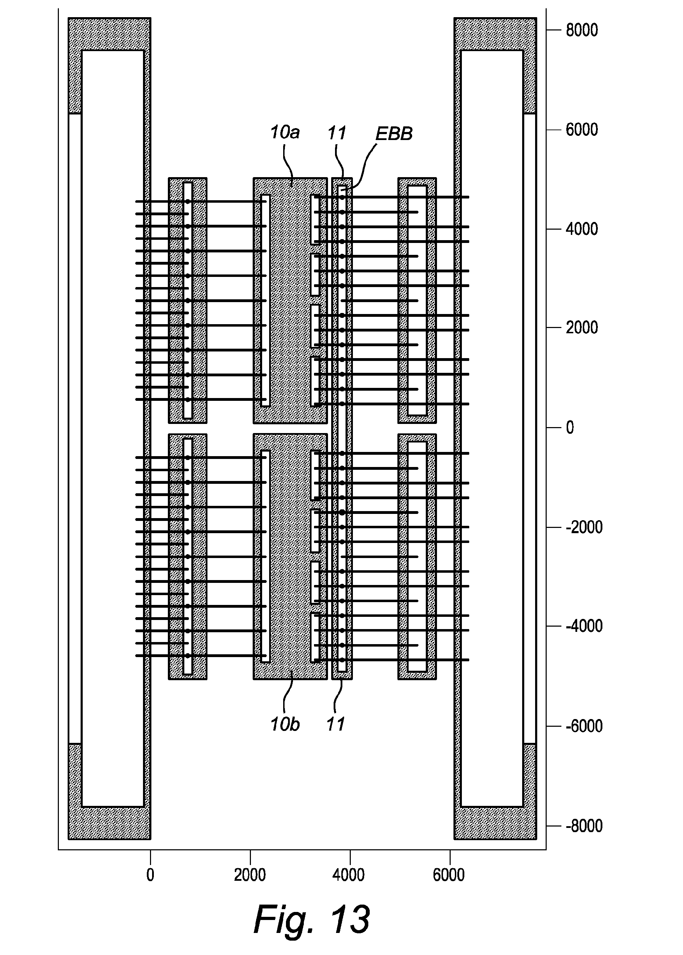

Fig. 2 shows the power-efficiency scaling issue. In this figure the power-added efficiency PAE is plotted as function of total gate-width Wg of the LDMOS transistor for two different devices. The figure discloses two curves SD, MD. The first curve SD relates to a first device comprising a semiconductor device with a single LDMOS die. The second curve MD relates to a second device comprising a semiconductor device with three LDMOS dies in parallel (the dies are all mounted on the same flange, which is illustrated in Fig. 13). Two effects can be observed from Fig. 2. Firstly, the efficiency PAE degrades when the total gate width Wg increases for a single die. Secondly, the efficiency is lower when multiple dies (in this case three dies) are put in parallel. Most likely this additional degradation has to do with distribution effects at chip package level. Due to variations in the impedance of the connections (bond-wires, leads, bond-pads, etc) to the dies, the input voltage phase is different for the individual dies. This asynchronicity results in additional power loss and thus a lower efficiency PAE.

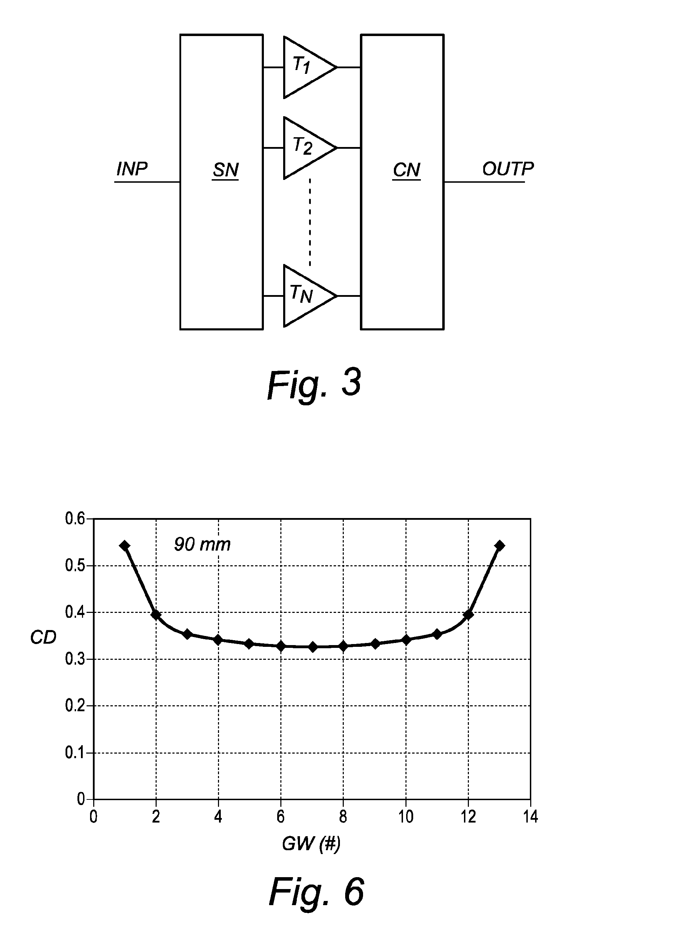

Fig. 3 shows a schematic representation of an LDMOS transistor which comprises a plurality of individual power amplifier transistors connected in parallel. One of the root causes of the efficiency degradation are distribution effects. An LDMOS transistor consists of a number of gate and drain fingers in parallel in an interdigitated design. Each finger can be seen as an individual power amplifier T1, T2, TN which is fed at the input INP via a splitter network SN and all the output powers are combined at the output OUTP by a combiner network CN.

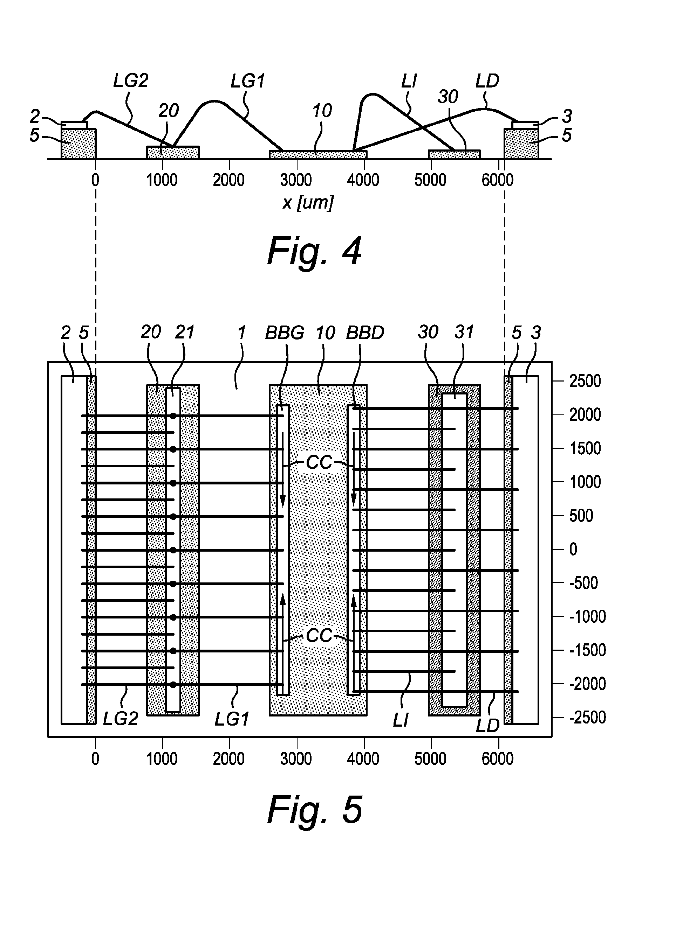

Fig. 4 shows a front-view of part of a packaged LDMOS transistor of the prior art. Fig. 5 shows a top-view of the LDMOS transistor of Fig. 4. The packaged LDMOS transistor comprises a source lead 1 onto which the semiconductor die 10 with the LDMOS is provided. At the edge of the package there is provided the insulating member 5 for receiving the gate lead 2 and the drain lead 3 respectively. Between the semiconductor chip 10 and the gate lead 2 there is provided a first impedance-matching capacitor 20. Between the semiconductor chip 10 and the drain lead 3 there is provided a second impedance-matching capacitor 30. The capacitors 20, 30 each comprise a bonding region 21, 31 respectively for externally connecting the capacitor to other nodes. A first set of bond-wires LG1 is provided between the gate terminal of the semiconductor chip 10 and the first impedance-matching capacitor 20. A second set of bond-wires LG2 is provided between the impedance-matching capacitor 20 and the gate lead 2. A third set of bond-wires Ll is provided between the drain terminal of the semiconductor chip 10 and the second impedance-matching capacitor 30. A fourth set of bond-wires LD is provided between the drain terminal of the semiconductor chip 10 and the drain lead 3. An impedance matching network configuration (capacitors and bond-wire inductances) as disclosed in Fig. 4 and Fig. 5, as such, is known to person skilled in the art. What is also known from the prior art is that so-called bond-bars may be provided at the respective gate and drain terminals of the semiconductor chip 10. Such bond-bars BBG, BBD typically act as current-compensation conductors in operational use (at RF frequencies and high output powers). In a configuration as illustrated in Figs. 4 and 5 the compensation current CC typically flows from respective ends of the current-compensation conductor to the middle of the conductor. This is due to the fact that due to coupling between the bond-wires, the respective impedances are changed such that the currents through the outer bond-wires is the largest.

Fig. 6 shows non-uniform current distribution in gate bond-wires due to inductive coupling between the wires. The simulated device was an RF LDMOS transistor. Fig. 6 discloses a graph in which a current level CD per individual bond-wire is calculated and plotted versus the respective bond-wire number GW ordered from edge to edge. The simulations clearly show that the current through the outer bond-wires is the largest.

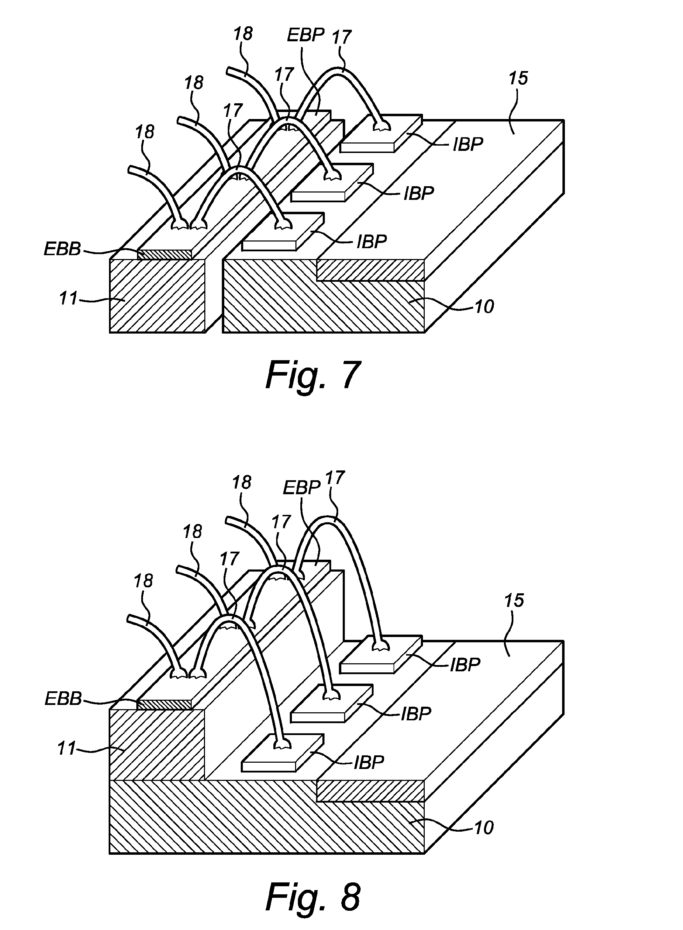

The inventors have noted that the known current-compensation techniques do not provide satisfactory results, i.e. the power efficiency is not increased to a point which is desired. Then it was discovered that this had to do with losses (resistive losses and induced eddy-currents) in the semiconductor chip due to the compensation currents, i.e. the semiconductor is by nature a lossy substrate. Then the idea was born to introduce a further substrate, which has by nature a lower loss then the semiconductor chip and move the current-compensation conductor to this further substrate. While the description until this point has focused a lot on LDMOS transistors, the basic idea of the invention is explained using Figs. 7 to 10. It must be noted that the basis idea is broader applicable than power amplifiers (based on RF LDMOS transistors).

Fig. 7 shows part of a semiconductor device in accordance with a first embodiment the invention. The figure discloses a first substrate region 10 having a first loss (in terms of resistive losses and/or eddy currents). In the first substrate region 10 there is provided an active element 15 (but this may also be a complete circuit). On the first substrate region 10 there is also provided a plurality of intermediate bond-pads IBP. The intermediate bond-pads IBP are connected (not shown) to an electrical node (not shown) in the active element 15. The figure also discloses a second substrate region 11 having a second loss that is lower than the first loss. On the second substrate region 11 there is provided the current-compensation conductor EBB. In Fig. 7 the current-compensation is conveniently provided as a bond-bar into which is merged with the external contact regions EBP (bond-pads) of the semiconductor chip. Connections between the external contact regions EBP and external parts (such as a passive component or a lead of a package) are formed by a set of bond-wires 18. The connection between the external contact regions EBP and the intermediate contact regions IBP are formed by another set of bond-wires 17. For the invention it is only of importance that a current-compensation conductor EBB is provided on a different substrate region 11 having a lower loss than the substrate region into which the active element 15 is integrated. In order to be able to perform the function of current-compensation the conductor EBB should be connected to at least two of the external contact regions. For all other aspects a lot of variations are possible which do not depart from the gist of the invention. Figs. 7 to 10 only illustrate a few of these variations and do therefore not form an exhaustive list of embodiments.

Fig. 8 shows part of a semiconductor device in accordance with a second embodiment of the invention. This embodiment will be discussed in as far as it differs from the previous embodiments. In this embodiment the second substrate region 11 is provided on part of the first substrate region 10. However, this is not essential. For example, the first substrate region 10 and the second substrate region 11 may be provided in a single substrate.

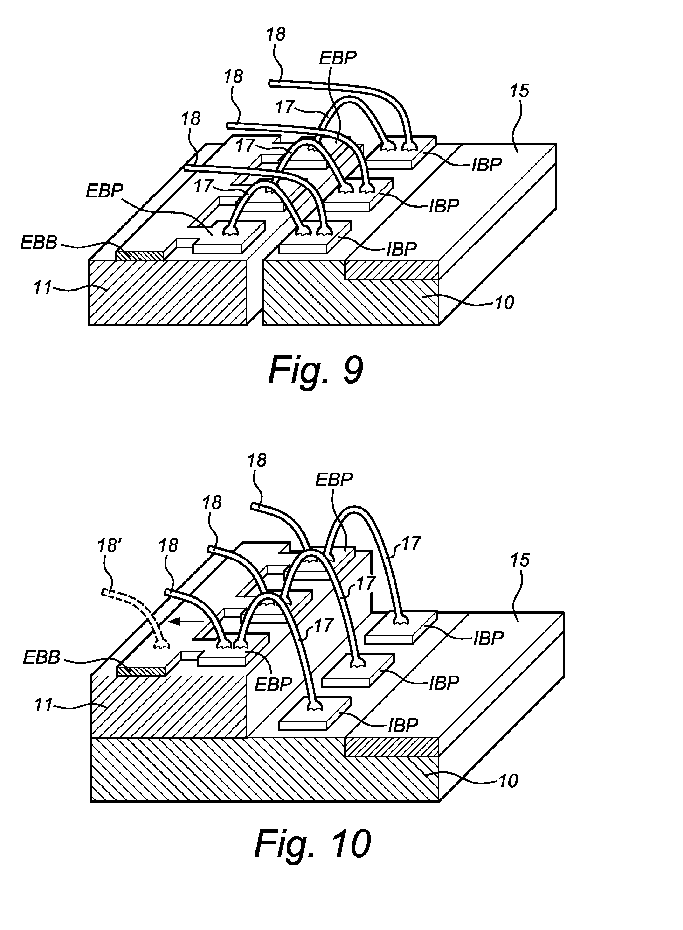

Fig. 9 shows part of a semiconductor device in accordance with a third embodiment of the invention. This embodiment will be discussed in as far as it differs from the previous embodiments. Whereas in Fig. 7 and 8 the external bond-bar EBB performs both the function of current-compensation conductor and bond-pad, in Fig. 9 these functions have been separated, i.e. the current-compensation conductor EBB is now placed besides the external contact regions EBP and electrically connected thereto. A further difference is that the intermediate contact-regions and the external contact regions have been exchanged (this variation is to be considered as independent from the first-mentioned variation of Fig. 9). As long as the bond-wires 17 between those regions have low impedance, such exchange does not significantly influence the operation of the device.

Fig. 10 shows part of a semiconductor device in accordance with a fourth embodiment of the invention. This embodiment will be discussed in as far as it differs from the previous embodiments. This embodiment differs from the embodiment in Fig. 8 in that, like in Fig. 9, the current-compensation conductor EBB has been provided as an additional component to the external contact regions EBP. Fig. 10 further illustrates another optional variation, namely that the external bond-wires 18' are shifted to the bond-bar EBB (thus making the bond-bar form the external contact regions), while the other bond-wires are connected.

The principle of the invention as illustrated in Figs. 7 to 10 may be applied to the RF power amplifier of Figs. 4 and 5 for example.

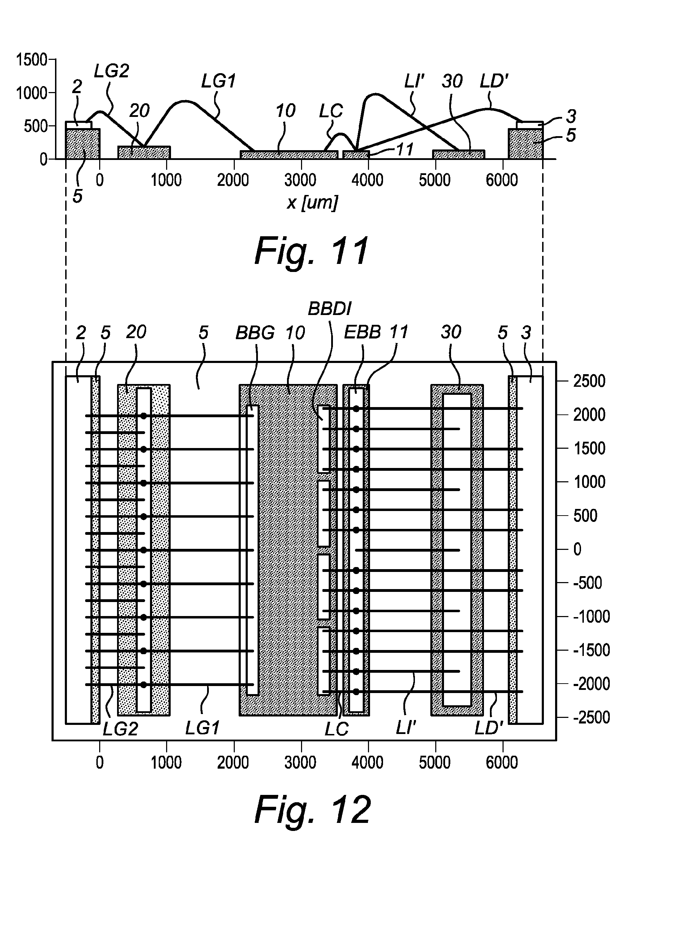

Fig. 11 shows a front-view of part of a packaged LDMOS transistor package in accordance with a further embodiment of the invention. Fig. 12 shows a top-view of the LDMOS transistor of Fig. 11. This embodiment will be discussed in as far as it differs from the prior art as discussed with respect to Figs. 4 and 5. Next to the drain terminal of the semiconductor chip 10 (the first substrate region) there is provided the second substrate region 11. On the second substrate region 11 there is provided the current-compensation conductor EBB (or bond-bar). The current-compensation conductor is connected to the drain terminal by means of a set of very short bond-wires LC. In this embodiment the bond-bar EBB has effectively become the new drain-terminal of the semiconductor chip 10. Because of this, a set of modified bond-wires LI' is now provided to connect the external bond-bar EBB to the second impedance-matching capacitor 30. Also, a further set of modified bond-wires LD' is provided to connect the external bond-bar EBB to the drain lead 3. It must be further noted that the bond-bar BBDI on the first substrate region 10 is now interrupted. This is advantageous, because in that case the compensation current is forced to flow through the external bond-bar EBB. The more the bond-bar BBDI is interrupted (the more the bond-bar BBD is split into smaller parts) the less compensation current will flow above the first substrate region 10 and thus the higher the power efficiency (due to smaller losses).

Fig. 13 shows a top-view of part of a packaged LDMOS transistor package in accordance with yet a further embodiment of the invention. This figure serves to illustrate that the external bond-bar EBB (current-compensation conductor) may also be shared by multiple-dies in a multi-die package. Fig. 13 clearly shows a first semiconductor die 10a (part of first substrate region) and a second semiconductor die 10b (part of first substrate region) which are connected in parallel. Both dies share the second substrate region 11 with the bond-bar EBB on it.

It must be stressed that the second substrate region 11 in accordance with the invention may be as simple as a dielectric layer, for instance silicon oxide, PCB or ceramic. Such layer may have a thickness between 10µm and 200µm for example. The bond-bar may comprise materials such as aluminum (Al), copper (Cu), gold (Au), platinum (Pt), etc.

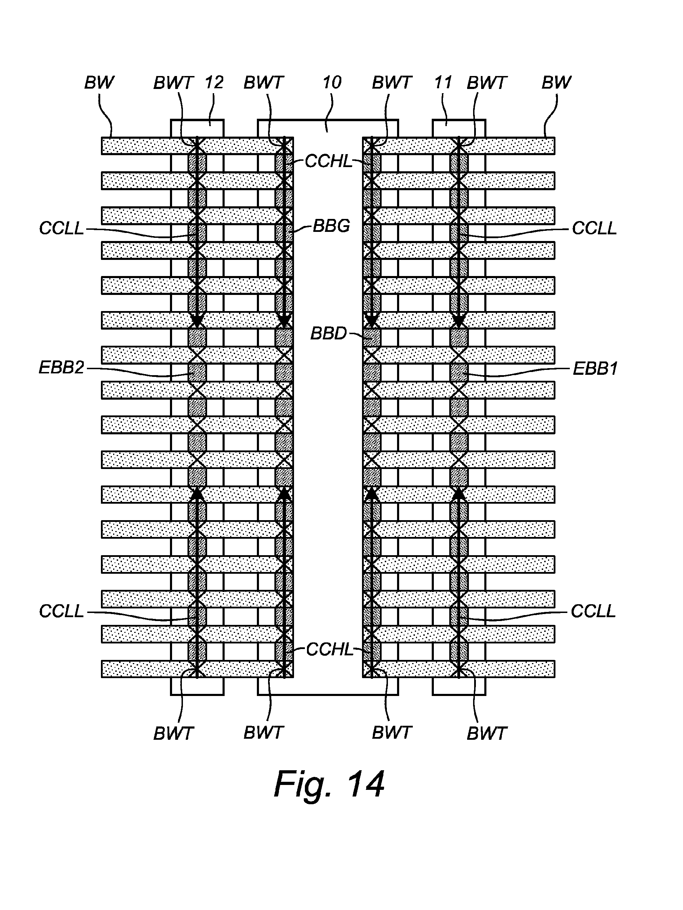

Figs. 14 to 16 illustrate a plurality of variations of the semiconductor device in accordance with various embodiments of the invention. In all figures the invention has been applied to both the gate-side as well as the drain-side of an RF LDMOS transistor. Thus a second substrate region 11 is provided next to the drain-side of the transistor having a first current-compensation conductor EBB1. Moreover, a third substrate region 12 is provided next to the gate-side of the transistor having a second current-compensation conductor EBB2. In all figures the bond-wires BW have been drawn schematically. The locations where such a bond-wire makes a connection (bond-wire tip BWT) with the bond-pad is marked with an "X".

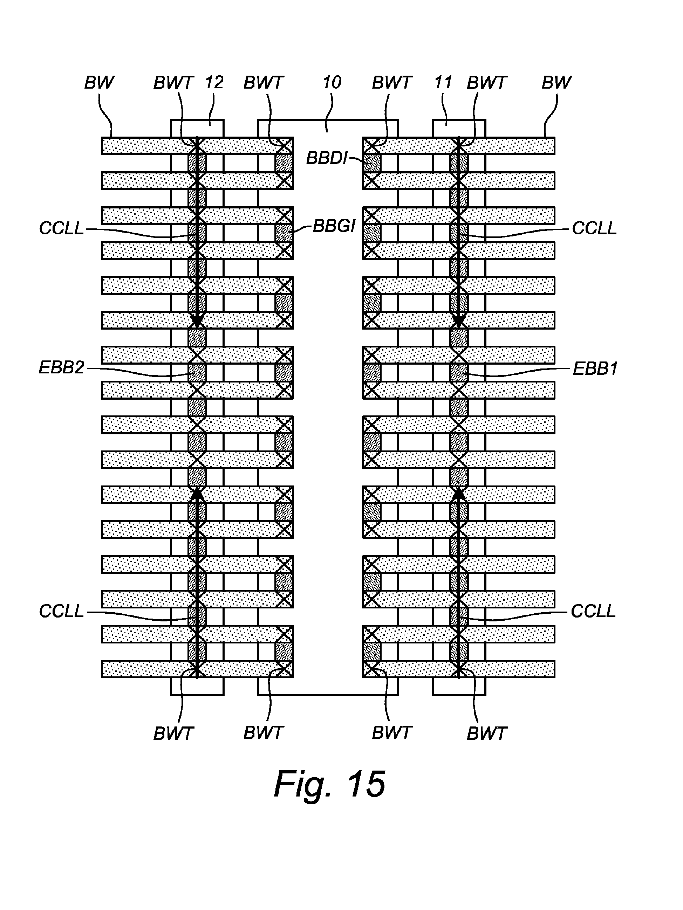

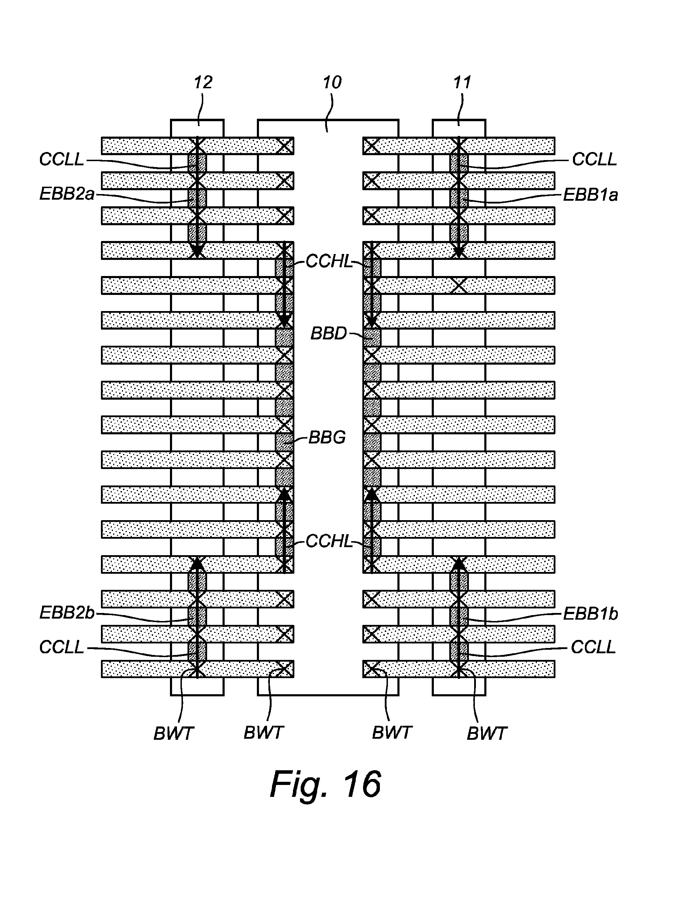

In Fig. 14 the invention is applied in addition to the current-compensation technique of the prior art. This means that bond bars BBG, BBD, EBB1, EBB2 are applied on both all substrate regions 10, 11, 12. The result is that compensation currents will flow through all bond-bars BBG, BBD, EBB1, EBB2. On the first substrate region 10 this implies high-loss compensation currents CCHL, whereas on the second and the third substrate regions 11, 12 this implies low-loss compensation currents CCLL. Nevertheless, as the bond-pars are connected in parallel, the overall current which flows above the first substrate region 10 is reduced and thus also the loss is reduced. In other words, the advantageous effect of the invention is still achieved. Significant improvements may be obtained when the bond-bars above the first substrate region 10 are formed as interrupted bond-bars BBGI, BBDI. This is illustrated in Fig. 15. In this example the bond-bars were split into eight sections. Fig. 16 illustrates that hybrid forms are also possible, i.e. that the external bond-bar may not be provided for all external contact regions. In Fig. 17 there is shown a first external bond-bar EBB1a at drain side of LDMOS transistor for the four outer bond-wires, and a second external bond-bar EBB1b at drain side of LDMOS transistor for the other four outer bond-wires at the drain-side. Likewise, there is shown a first external bond-bar EBB2a at gate side of LDMOS transistor, and a second external bond-bar EBB2b at gate side of LDMOS transistor. Referring back to the section where it was discussed that the compensation current is the highest for the outer wires, this embodiment may still be effective, because it provides for these outer wires the current-compensation conductor.

The invention is about reducing the losses of the equalizing currents. One way to accomplish this is to address the two root-causes of the non-uniform steering already mentioned (lead, coupling of bond-wires) so that equalization is not necessary. Prior art exists describing ways to do this, for example, by changing the height or pitch of the outer bond-wires to match the transistor more uniformly. In practice it is not easy to realize and see the improvements therefore the equalizing bars are still a necessity. In fact, the big advantage of having these bars is that the matching design becomes independent of the distribution effect problem.

In the invention a structure is placed comprising a metal strip which is connected to the semiconductor chip with short bond-wires. From this passive structure the matching continues as normal towards the output lead. In the invention, at least part of the equalizing function is done on the passive structure with lower losses yielding higher power efficiency.

Some remarks concerning the implementation can be made:
- The invention is not limited to LDMOS transistors but can be used with any active technology like GaN, CMOS etc;
- The new proposed passive structure can be made in different technologies like on high resistive silicon, GaAs, glass, ceramic, sapphire, LTCC, PCB etc;
- The width of the bond-bar (or equalizing bar) can have any dimensions and shapes. The wider the bar, the less the inductance in the bar which is beneficial but also requires more space in the package;
- The bond-bar can also be placed at the input. In case of an amplifier circuit it may not give a higher efficiency, but it will improve the gain;
- The bond-bar on silicon can be split in any number of equal sections or non-equal sections;
- The bond-bar can be integrated with the impedance-matching capacitors, and
- The bond-bar has preferably an as low as possible capacitance to ground (source flange in some embodiments).

The invention thus provides a semiconductor device comprising: i) a first substrate region 10 comprising an active element 15, the active element 15 comprising an electrical node; ii) a plurality of external contact regions EBP for being wire bonded to other parts 2, 3, 20, 30, 40, 50 of the semiconductor device, wherein the external contact regions EBP are each electrically connected to the electrical node of the active element 15; iii) a second substrate region 11 having a lower loss than the first substrate region 10, wherein loss is defined as resistive loss and/or loss due to eddy-currents in the respective substrate region 10, 11, and iv) a current-compensation conductor EBB, EBB1, EBB2 provided on the second substrate region 11 and being electrically connected to at least two of the plurality of external contact regions EBP. The invention provides a semiconductor device with a current-compensation conductor having an improved RF performance, because the current-compensation conductor is provided on a low-loss substrate.

The invention may be applied in various application areas, but in particular in high-frequency power amplifiers, wherein parasitic impedances of external connections (bond-wires) play a dominant role in the circuit behavior.

Various variations of the invention are possible and do not depart from the scope of the invention as claimed.

It should be noted that the above-mentioned embodiments illustrate rather than limit the invention, and that those skilled in the art will be able to design many alternative embodiments without departing from the scope of the appended claims. In the claims, any reference signs placed between parentheses shall not be construed as limiting the claim. Use of the verb "comprise" and its conjugations does not exclude the presence of elements or steps other than those stated in a claim. The article "a" or "an" preceding an element does not exclude the presence of a plurality of such elements. The invention may be implemented by means of hardware comprising several distinct elements, and by means of a suitably programmed computer. In the device claim enumerating several means, several of these means may be embodied by one and the same item of hardware. The mere fact that certain measures are recited in mutually different dependent claims does not indicate that a combination of these measures cannot be used to advantage. Throughout the Figures, similar or corresponding features are indicated by same reference numerals or labels.

## Claims

1. A semiconductor device comprising:
- a first substrate region (10) comprising an active element (15), the active element (15) comprising an electrical node;
- a plurality of external contact regions (EBP) for being wire bonded to other parts (2, 3, 20, 30, 40, 50) of the semiconductor device, wherein the external contact regions (EBP) are each electrically connected to the electrical node of the active element (15);
a second substrate region (11) having a lower loss than the first substrate region (10), wherein loss is defined as resistive loss and/or loss due to eddy-currents in the respective substrate region (10, 11), and
a current-compensation conductor (EBB, EBB1, EBB2) provided on the second substrate region (11) and being electrically connected to at least two of the plurality of external contact regions (EBP).

2. The semiconductor device as claimed in claim 1, wherein the plurality of the external contact regions (EBP) is provided on the second substrate region (11).

3. The semiconductor device as claimed in claim 2, wherein the current-compensation conductor (EBB, EBB1, EBB2) comprises the plurality of external contact regions (EBP).

4. The semiconductor device as claimed in claim 3, further comprising a plurality of intermediate contact regions (IBP) for connecting the plurality of external contact regions (EBP) to the electrical node.

5. The semiconductor device as claimed in claim 1, wherein the plurality of the external contact regions (EBP) is provided on the first substrate region (10).

6. The semiconductor device as claimed in claim 5, further comprising a plurality of intermediate contact regions (IBP) for connecting the plurality of external contact regions (EBP) to the current-compensation conductor (EBB, EBB1, EBB2).

7. The semiconductor device as claimed in claim 4 or 6, wherein the plurality of external contact regions (EBP) is connected to the plurality of intermediate contact regions (IBP) by means of bond wires (17).

8. The semiconductor device as claimed in any one of the preceding claims, wherein the first substrate region (10) and second substrate region (11) are provided on separate substrates.

9. The semiconductor device as claimed in any one of claims 1 to 7, wherein the first substrate region (10) and second substrate region (11) are provided on or form part of a single substrate.

10. The semiconductor device as claimed in any one of the preceding claims, wherein the active element (15) comprises a further electrical node, the semiconductor device further comprising:
- a plurality of further external contact regions for being wire bonded to further other parts (2, 3, 20, 30, 40, 50) of the semiconductor device, wherein the further external contact regions are each electrically connected to the further electrical node of the active element (15);
a third substrate region (12) having a lower loss than the first substrate region (10), wherein loss is defined as resistive loss and/or loss due to eddy-currents in the respective substrate region (10, 12), and
a further current-compensation conductor (EBB2) provided on the third substrate region (12) and being electrically connected to at least two of the plurality of further external contact regions.

11. The semiconductor device as claimed in any one of the preceding claims, wherein the first substrate region comprises one of CMOS technology, GaN technology, or RF LDMOS technology.

12. The semiconductor device as claimed in any one of the preceding claims, wherein the active element comprises an RF power transistor.

13. The semiconductor device as claimed in claim 12, wherein the RF LDMOS transistor comprises a plurality of individual transistors connected in parallel.

14. The semiconductor device as claimed in any one of the preceding claims, wherein the electrical node is an output of an amplifier circuit.

15. The semiconductor device as claimed in any one of the preceding claims, wherein the further electrical node is an input of an amplifier circuit.
